# DEMANDE DE BREVET EUROPEEN

(11) **EP 1 813 953 A2**
(43) Date de publication de la demande: **01.08.2007**
(21) Numéro de dépôt: 07101031.8
(22) Date de dépôt: 23.01.2007
(51) Int. Cl.: G01R 33/04

(54) **Magnétomètre de type fluxgate à excitation pulsée et détection échantillonnée**

(30) Priorité: 26.01.2006 FR 0650280
(71) Demandeur: COMMISSARIAT A L'ENERGIE ATOMIQUE, 75015 Paris (FR)
(72) Inventeur: Beranger, Marc, 38410, SAINT MARTIN D'URIAGE (FR)
(74) Mandataire: Poulin, Gérard

(57) **Abrégé**

L'invention concerne un dispositif de mesure de champ magnétique doté d'un magnétomètre à fluxgate, le dispositif comprenant : un capteur magnétique ou capteur magnétique (110,210) apte à délivrer au moins un signal de sortie (S₂), et doté d'au moins un noyau magnétique, des moyens d'excitation dudit noyau magnétique, comportant des moyens générateurs (120,220,420) aptes à émettre un signal d'excitation (S₁, S₁₀) en entrée du circuit ou capteur magnétique, sous forme d'une succession d'impulsions (125,126,225,226), des moyens d'échantillonnage (130,230,330,430) du signal de sortie (S₁) du circuit magnétique (110,210), comprenant en outre des moyens pour : consécutivement à l'émission d'au moins une impulsion donnée de ladite succession d'impulsions, déclencher au moins une acquisition du signal de sortie (S₂) du circuit magnétique par les moyens d'échantillonnage pendant la durée de ladite impulsion donnée. L'invention concerne également un procédé mis en oeuvre à l'aide d'un tel dispositif.

## Description

### DOMAINE TECHNIQUE

La présente invention se rapporte au domaine des magnétomètres ou capteurs magnétiques, et met en oeuvre un dispositif électronique ou microélectronique de détection ou/et de mesure de champ magnétique, comportant un capteur magnétique de type magnétomètre à fluxgate, ainsi que des moyens améliorés d'excitation pulsée du capteur et de détection échantillonnée en sortie du capteur. L'invention concerne également un procédé amélioré de détection ou/et de mesure à l'aide d'un tel dispositif.

Le dispositif et procédé suivant l'invention, apportent des améliorations notamment en termes de rapport signal à bruit, de consommation, et de bande passante.

### ETAT DE LA TECHNIQUE ANTERIEURE

Les magnétomètres à « flux-gate » trouvent emploi dans des mesures de champs magnétiques qui peuvent être faibles ou même très faibles, par exemple de l'ordre du microtesla avec une résolution de l'ordre du nanotesla ou même de l'ordre de plusieurs picoteslas, suivant les dimensions du magnétomètre. Les magnétomètres peuvent s'appliquer au domaine de la microélectronique et être incorporés par exemple dans des circuits intégrés. Ces magnétomètres sont alors fabriqués grâce à des techniques de réalisation en couches minces.

Un dispositif électronique ou microélectronique comportant un magnétomètre de type « flux-gate », est classiquement doté : d'un capteur, de moyens d'excitation ou d'un circuit d'excitation apte à délivrer un signal périodique d'excitation au capteur, et de moyens de détection ou d'un circuit de détection en sortie du capteur. Le capteur comprend généralement un circuit magnétique ou noyau magnétique, ainsi qu'un ou plusieurs bobinages chargés de l'excitation du circuit magnétique et un ou plusieurs bobinages « récepteurs » ou de « détection » chargés de la mesure. Ces éléments fonctionnent en collaboration.

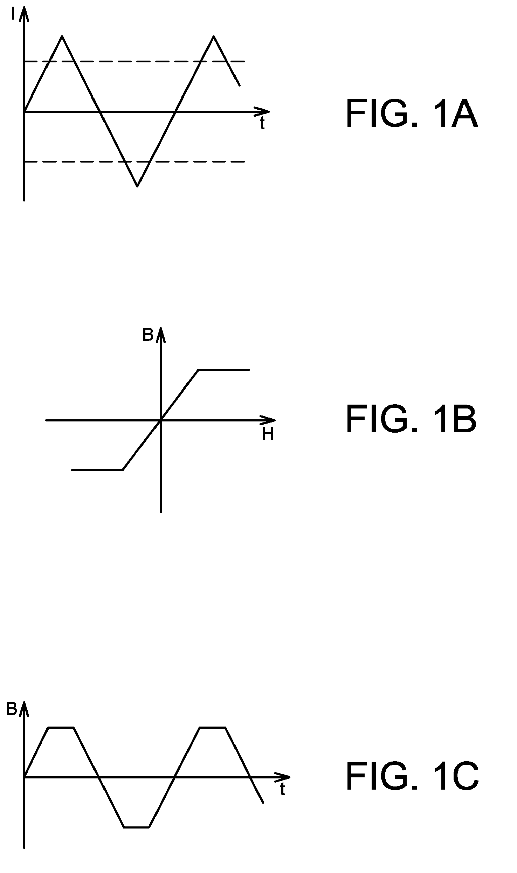

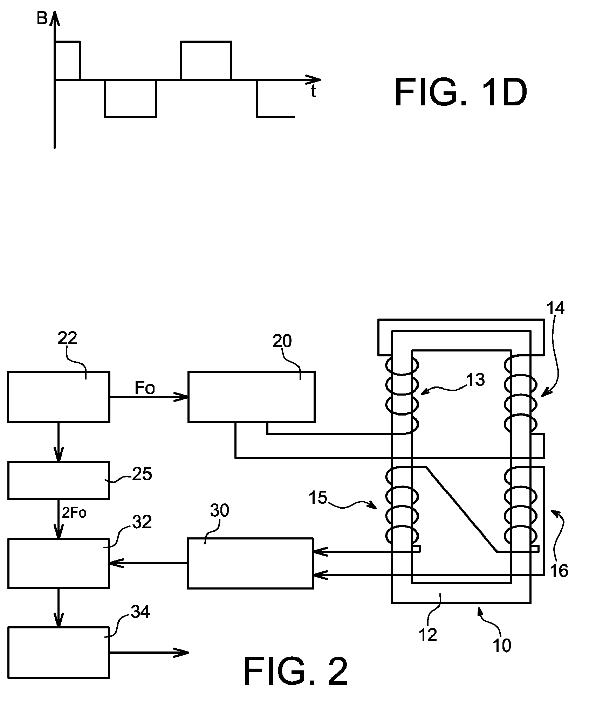

Le signal d'excitation délivré au capteur est généralement sinusoïdal ou triangulaire comme sur la figure 1A. Ce signal d'excitation sature périodiquement le circuit magnétique du capteur, sous une induction magnétique alternativement positive et négative. Du fait de la non-linéarité de la courbe d'aimantation du matériau magnétique formant le noyau, le signal induit aux bornes des bobines de détection comporte essentiellement des composantes d'harmonique impaires de la fréquence d'excitation (figures 1B, 1C, 1D illustrant respectivement, une courbe d'aimantation du noyau, une courbe d'induction dans le matériau magnétique du noyau, ainsi qu'un signal de tension induite). En présence d'un champ magnétique extérieur, le cycle d'hystérésis du matériau magnétique n'est plus symétrique et l'on observe des harmoniques paires de la fréquence d'excitation.

Un exemple de dispositif suivant l'art antérieur de mesure de champ magnétique doté d'un magnétomètre à fluxgate, est illustré sur la figure 2. Ce dispositif comprend un capteur 10 doté d'un circuit magnétique comportant un noyau magnétique 12. Des moyens d'excitation du noyau 12 sont prévus en entrée du circuit magnétique et comprennent un générateur de courant 20 apte à délivrer un signal d'excitation du type de celui illustré en liaison avec la figure 1A, la fréquence f₀ du signal d'excitation étant imposée par un circuit d'horloge ou une horloge 22. Le générateur de courant 20 est relié à deux bobinages d'excitation 13 et 14. Le circuit magnétique 10 comporte également deux bobinages de détection 15 et 16 câblés en opposition de sorte que les composantes d'harmoniques paires s'ajoutent et les composantes d'harmoniques impaires se soustraient. Du signal en sortie du capteur, on extrait un signal dit « utile » à l'aide d'un préamplificateur et d'un filtre passe bande (bloc référencé 30 sur la figure 2) situé en sortie des deux bobinages de détection 15 et 16 et d'un circuit de détection synchrone 32 situé après le filtre passe bande. Le circuit de détection synchrone 30 réalise une détection du signal utile à une fréquence qui peut être de l'ordre, ou égale à, 2*f₀. Cette fréquence 2*f₀ dite « de détection », peut être imposée au circuit de détection synchrone 32, par l'intermédiaire d'un déphaseur 25 situé en sortie de l'horloge 22. En sortie du circuit de détection synchrone 30 peut être également prévu un filtre passe bas 34. Le dispositif peut éventuellement avoir un fonctionnement asservi. Dans ce cas, le signal en sortie du circuit de détection synchrone sert de signal d'erreur à une boucle d'asservissement.

Pour un micro-magnétomètre à fluxgate, la forme d'onde, l'amplitude, la fréquence, la phase entre le signal d'excitation et la détection synchrone sont des paramètres dépendants les uns des autres, ce qui limite l'adaptation du dispositif à une seule fréquence de fonctionnement.

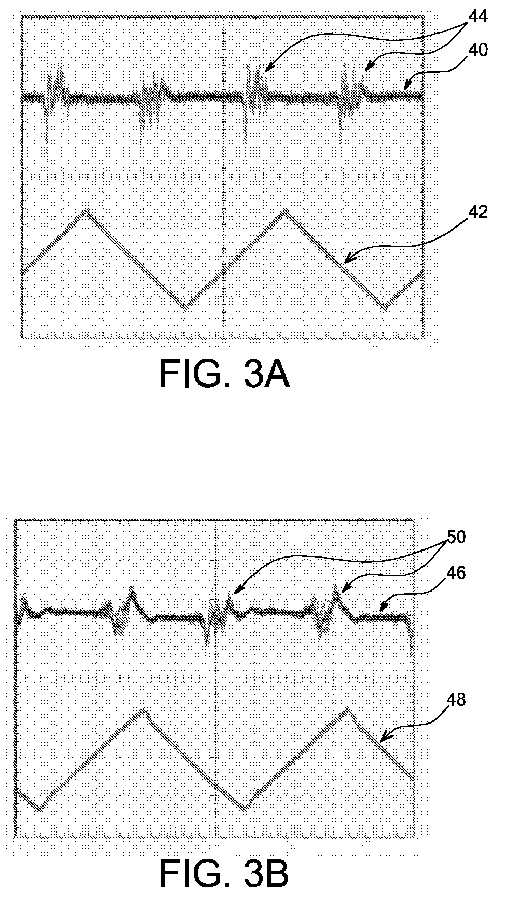

Avec un dispositif tel que précédemment décrit, on observe généralement un bruit important dans le signal utile lors de phases de saturation et de dé-saturation du circuit magnétique 10. La figure 3A illustre dans un tel type de dispositif, un signal 40 en sortie du capteur 10 en réponse à un signal d'excitation 42 de fréquence de l'ordre de 200 kHz, sans que le circuit magnétique du capteur soit soumis à un champ extérieur. On observe que le signal 40 de sortie du capteur 10 comporte un bruit 44 important lors de la saturation et de la dé-saturation du circuit magnétique. La figure 3B illustre quant à elle, un signal de sortie 46 du circuit magnétique 10, en réponse à un signal d'excitation 48 de fréquence de l'ordre de 1 MHz, sans que le circuit magnétique 10 soit soumis à un champ extérieur. Le signal de sortie 46 comporte également un bruit 50 important.

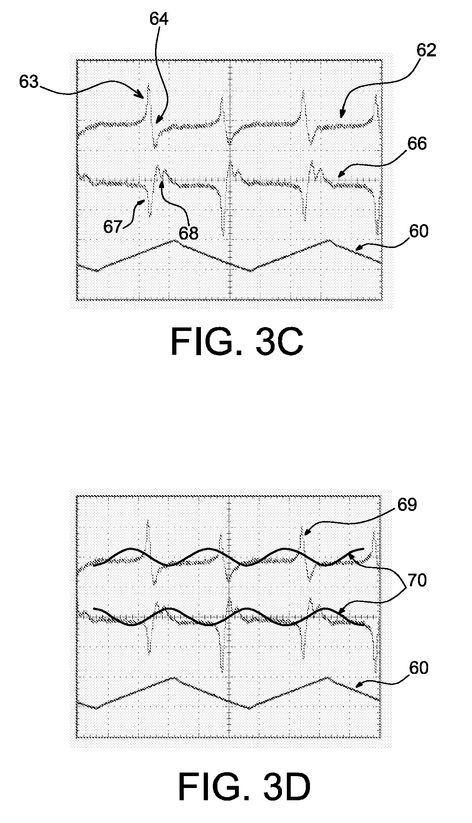

La figure 3C illustre quant à elle des signaux 62, 66, en sortie du capteur 10, pour un signal d'excitation 60 triangulaire de fréquence de l'ordre de 1 MHz. En présence d'un champ magnétique extérieur de + 15 µT, on peut observer dans un tel dispositif, un signal utile 62 comportant des alternances positives 63 puis des alternances négatives 64 à chaque saturation du circuit magnétique, deux fois par période du signal d'excitation 60. En présence d'un champ magnétique de -15 µT, un signal utile 66 comportant des alternances négatives puis des alternances positives, deux fois par période du signal d'excitation. La phase entre le signal d'excitation 60 et les moyens de détection synchrones doit être parfaitement ajustée mais le capteur induit un déphasage dépendant de la fréquence, de l'amplitude d'excitation, de la température. Ce problème de phase est à l'origine de dérives de décalage (« offset » selon la terminologie anglo-saxonne) et de phénomène de bruits très basse fréquence dans le signal utile.

Pour un magnétomètre fluxgate à détection synchrone, l'origine du signal que l'on détecte est la non linéarité de la courbe d'aimantation du matériau magnétique. Cette non-linéarité fait apparaître tous les harmoniques pairs 69 du signal d'excitation 60. Pour un dispositif doté d'une détection synchrone 32 tel que décrit précédemment, seule l'harmonique de rang 2 du signal 70 en sortie du circuit magnétique 10 est exploitée. Les harmoniques de rangs supérieurs sont rejetés par le filtre passe bas 34 (figure 3D)

De manière générale, lorsqu'un magnétomètre à fluxgate est associé à des moyens d'excitation délivrant un signal triangulaire ou sinusoïdal, et/ou associé à un circuit de détection synchrone, des instabilités ou des phénomènes de bistabilité apparaissent. Ce défaut se manifeste par des sauts ou des décalages dans le signal en sortie du capteur magnétique.

Le document FR 01 10853 présente une solution pour réduire les phénomènes d'offset, et en particulier un procédé de stabilisation d'un magnétomètre doté d'un noyau magnétique, des bobinages dont au moins un bobinage actif et un bobinage récepteur, le bobinage actif étant agencé de façon à créer un champ magnétique d'excitation dans le noyau, qui sensibilise le bobinage récepteur, des moyens de passage d'un courant alternatif à une fréquence d'excitation dans le bobinage actif et des moyens de mesure d'une tension induite à une fréquence double de la fréquence d'excitation dans le bobinage récepteur. Ce procédé comprend au moins une étape consistant à soumettre le bobinage récepteur à un champ magnétique alternatif supplémentaire.

Le document « Pulse Excitation of the Micro-fluxgate Sensors, Pavel Ripka et al, octobre 12, 2000) présente quant à lui, une variante de dispositif de mesure de champ magnétique comprenant un magnétomètre à fluxgate ainsi qu'un générateur de courant délivrant un signal carré de rapport cyclique de l'ordre de 20% en entrée du circuit magnétique du magnétomètre. La détection d'un signal en sortie du circuit magnétique est réalisée à l'aide d'un circuit de détection synchrone de type « SR844 lock in amplifier » de la société Stanford Research Systems. Un tel dispositif permet d'obtenir des performances améliorées notamment en termes de consommation, mais présente des dérives d'offset et de bruit très basse fréquence tels que décrits précédemment.

Il se pose le problème de trouver un nouveau dispositif électronique ou microélectronique comportant un magnétomètre à fluxgate, dont les performances sont améliorés en termes de rapport signal sur bruit, consommation et bande passante.

### EXPOSÉ DE L'INVENTION

La présente invention a pour but de présenter un dispositif de mesure de champ magnétique doté d'au moins un magnétomètre à fluxgate, et comprenant des moyens améliorés d'excitation du capteur ou circuit magnétique du magnétomètre, ainsi que des moyens améliorés de détection du signal ou de signaux en sortie dudit capteur ou dudit circuit magnétique.

L'invention concerne tout d'abord un dispositif de mesure de champ magnétique doté d'un magnétomètre à fluxgate, le dispositif comprenant:
- un capteur magnétique doté d'au moins un noyau magnétique et d'une pluralité de bobinages, et apte à délivrer au moins un signal de sortie,
- des moyens générateurs d'impulsions aptes à émettre au moins un signal d'excitation en entrée du capteur magnétique, sous forme d'une succession d'impulsions dites « d'excitation »,
- des moyens d'échantillonnage du signal de sortie du capteur magnétique,
   le dispositif comprenant en outre des moyens, par exemple les moyens générateurs d'impulsions pour, consécutivement à l'émission d'au moins une impulsion d'excitation donnée de ladite succession d'impulsions d'excitation et pendant la durée de ladite impulsion d'excitation donnée, déclencher au moins une acquisition du signal de sortie du capteur magnétique par lesdits moyens d'échantillonnage.

Le dispositif suivant l'invention peut être un dispositif microélectronique.

Une détection « échantillonnée » exploite l'amplitude crête à crête du signal de sortie du capteur et permet, contrairement à une détection synchrone classique, d'exploiter tous les harmoniques de ce signal de sortie.

Selon une mise en oeuvre particulière, le dispositif peut comprendre des moyens pour : déclencher au moins une acquisition du signal de sortie du circuit magnétique pendant les durées respectives de chacune desdites impulsions de ladite succession d'impulsions. Un tel dispositif peut éventuellement comprendre des moyens générateurs d'impulsions associés à plusieurs capteurs magnétiques multiplexés, les capteurs étant associés chacun à des moyens de détection échantillonnée ou d'échantillonnage.

Un tel dispositif présente un rapport signal à bruit ainsi qu'une consommation améliorées par rapport aux dispositifs suivant l'art antérieur, et en particulier par rapport à ceux comportant des moyens de détection synchrones en sortie du capteur magnétique. Dans un dispositif suivant l'invention, les phénomènes d'instabilité ou de bi-stabilité, sont également réduits par rapports aux dispositifs suivant l'art antérieur.

Avec un tel dispositif, la bande passante est également réglable par la fréquence dudit signal d'excitation.

Selon une possibilité, le signal d'excitation peut comprendre ou être formé d'impulsions d'excitation successives de signes opposés. Cela peut permettre de limiter les phénomènes de décalages ou d'« offset» selon la terminologie anglo-saxonne, du signal en sortie du capteur.

Selon une possibilité, qui peut être combinée avec la précédente, lesdites impulsions d'excitation peuvent également avoir des durées respectives ou/et des amplitudes respectives égales.

Selon une autre possibilité, qui peut être combinée avec les précédentes, lesdites impulsions peuvent également avoir une forme rectangulaire.

Le signal d'excitation est de préférence formé d'impulsions brèves.

Les moyens de détection échantillonnée ou d'échantillonnage peuvent être régis par au moins un signal de commande à deux états, généré par les moyens générateurs.

Selon une première mise en oeuvre, les moyens d'échantillonnage peuvent être prévus pour, consécutivement à ladite émission de ladite impulsion donnée, à effectuer une acquisition du signal de sortie du capteur pendant un intervalle de temps donné inférieur à la durée de ladite impulsion donnée, ledit intervalle de temps étant compris entre un instant situé un délai prédéterminé, de préférence non-nul, après le début de ladite impulsion et un instant situé un autre délai prédéterminé, de préférence non-nul, avant la fin de ladite impulsion donnée. Cela peut permettre d'effectuer une acquisition du signal à un instant où les phénomène de couplage électromagnétique capacitif ou/et inductif sont minimaux ou nuls.

Selon cette première mise en oeuvre, les moyens d'échantillonnage peuvent être prévus en outre, pour effectuer une moyenne ou un lissage du signal de sortie du capteur magnétique pendant ledit intervalle de temps donné.

Un signal dit « lissé » peut être formé suite à ladite moyenne ou audit lissage du signal de sortie. Selon la première mise en oeuvre, les moyens d'échantillonnage peuvent être aptes, en outre, à mémoriser ledit signal « lissé », après ledit intervalle de temps donné et jusqu'à au moins une autre impulsion de ladite succession d'impulsions.

Selon la première mise en oeuvre, les moyens d'échantillonnage peuvent comprendre des moyens formant un interrupteur, par exemple analogique.

Selon la première mise en oeuvre, les moyens d'échantillonnage peuvent également comprendre des moyens formant un filtre passe bas.

Selon une deuxième mise en oeuvre, les moyens d'échantillonnage peuvent être prévus pour : consécutivement à ladite émission de ladite impulsion d'excitation donnée, à effectuer au moins une acquisition du signal de sortie du capteur à un instant donné prédéterminé situé après le début et avant la fin de ladite impulsion d'excitation donnée.

La proximité des bobines d'excitation et de détection peut éventuellement provoquer un couplage électromagnétique qui ne comporte pas de signal utile.

Ledit instant donné prédéterminé peut être situé au milieu de ladite impulsion d'excitation donnée. Cela peut permettre d'effectuer une acquisition du signal à un instant où les phénomène de couplage électromagnétique capacitif ou/et inductif sont minimaux ou nuls.

Selon la deuxième mise en oeuvre, les moyens d'échantillonnage peuvent être prévus pour effectuer une mémorisation du signal de sortie du capteur audit instant donné prédéterminé.

Selon la deuxième mise en oeuvre, les moyens d'échantillonnage peuvent comprendre au moins un échantillonneur-bloqueur.

Selon une variante, les moyens d'échantillonnage peuvent être aptes en outre consécutivement à l'émission d'une impulsion, à effectuer une conversion analogique/numérique du signal de sortie du circuit à partir ou audit instant donné prédéterminé. Les moyens d'échantillonnage peuvent comprendre des moyens formant un convertisseur analogique/numérique.

Selon une mise en oeuvre du dispositif de mesure, ce dispositif est susceptible de fonctionner en asservissement et peut comprendre un ou plusieurs bobinages de contre réaction, et une boucle de rétroaction dotée de moyens pour produire un signal de contre réaction destiné auxdits bobinages de contre réaction.

Lesdits moyens pour produire un signal de contre réaction peuvent comprendre des moyens formant au moins un intégrateur.

Lesdits moyens pour produire un signal de contre réaction peuvent comprendre des moyens pour mémoriser une information relative à l'amplitude dudit signal de contre réaction entre deux impulsions d'excitation.

Selon une mise en oeuvre du dispositif, les moyens pour produire un signal de contre réaction peuvent être régis par au moins un signal de commande de contre réaction généré par les moyens générateurs d'impulsions sous forme d'une succession d'impulsions dites « de commande de contre réaction ».

Selon cette mise en oeuvre, les variations du signal de commande de contre réaction peuvent être dépendantes des variations du signal d'excitation, les variations du signal de commande d'échantillonnage étant elles mêmes dépendantes des variations du signal d'excitation.

Selon une possibilité, le dispositif de mesure selon l'invention peut comprendre en outre: des moyens pour, consécutivement à une variation selon une rapidité donnée, du champ magnétique dans lequel baigne le capteur magnétique, moduler la fréquence de répétition desdites impulsions du signal d'excitation en fonction de ladite rapidité donnée de variation.

L'invention concerne également un procédé de mesure de champ magnétique à l'aide d'un dispositif doté d'un magnétomètre à fluxgate, le dispositif comprenant :
- un circuit magnétique ou capteur magnétique, doté d'au moins un noyau magnétique, et apte à délivrer au moins un signal de sortie,
- des moyens d'excitation du noyau magnétique, comportant des moyens générateurs aptes à émettre un signal d'excitation en entrée du circuit magnétique ou du capteur magnétique sous forme d'une succession d'impulsions dites « d'excitation »,
- des moyens d'échantillonnage du signal de sortie du circuit magnétique, le procédé comprenant les étapes consistant à :

- émettre au moins une impulsion « d'excitation » en entrée du capteur,
- déclencher, consécutivement à ladite impulsion, au moins une acquisition du signal de sortie du capteur magnétique par les moyens d'échantillonnage pendant la durée de ladite impulsion.

Selon une mise en oeuvre particulière, le procédé peut comprendre les étapes consistant à :
- émettre une succession d'impulsions « d'excitation »,
- déclencher, consécutivement à chacune desdites impulsions « d'excitation », au moins une acquisition du signal de sortie du capteur ou circuit magnétique par les moyens d'échantillonnage pendant les durées respectives de ces impulsions « d'excitation ».

Le signal d'excitation peut être formé d'impulsions « d'excitation » successives de signes respectifs opposés.

Lesdites impulsions « d'excitation », peuvent avoir des durées respectives ou/et des amplitudes respectives égales.

Lesdites impulsions « d'excitation », peuvent avoir une forme rectangulaire.

Les moyens d'échantillonnage peuvent être régis par au moins un signal de commande d'échantillonnage à deux états, généré par lesdits moyens générateurs.

Selon un première mise en oeuvre du procédé, ce dernier peut comprendre en outre: consécutivement à ladite émission de ladite impulsion « d'excitation », au moins une acquisition du signal de sortie du capteur pendant un intervalle de temps donné inférieur à la durée de ladite impulsion « d'excitation », ledit intervalle de temps étant compris entre un instant situé un délai prédéterminé après le début de ladite impulsion et un instant situé un autre délai prédéterminé avant la fin de ladite impulsion « d'excitation ».

Selon cette première mise en oeuvre, le procédé peut comprendre une étape consistant à effectuer une moyenne ou un lissage du signal de sortie du circuit ou capteur magnétique pendant ledit intervalle de temps donné.

Selon une deuxième possibilité de mise en oeuvre du procédé, ce dernier peut comprendre consécutivement à ladite émission de ladite impulsion « d'excitation », au moins une acquisition du signal de sortie du capteur à un instant donné prédéterminé situé après le début et avant la fin de ladite impulsion « d'excitation », par exemple un instant situé au milieu de ladite impulsion « d'excitation ».

Selon ladite deuxième possibilité de mise en oeuvre, le procédé peut comprendre en outre : une mémorisation du signal de sortie du circuit audit instant donné prédéterminé.

Selon ladite deuxième possibilité de mise en oeuvre, le procédé peut comprendre en outre : consécutivement à l'émission d'une impulsion, une conversion analogique numérique du signal de sortie du circuit audit instant donné prédéterminé.

Selon une possibilité de mise en oeuvre, le dispositif peut comprendre en outre : un ou plusieurs bobinages de contre réaction, et une boucle de rétroaction dotée de moyens pour produire un signal de contre réaction destiné auxdits bobinages de contre réaction, et dans lequel les moyens pour produire ledit signal de contre réaction sont régis par au moins un signal de commande de contre réaction généré par les moyens générateurs d'impulsions sous forme d'une succession d'impulsions dites « de commande de contre réaction », ladite impulsion d'excitation émise à l'étape a) du procédé peut avoir été déclenchée consécutivement à une émission par les moyens générateurs d'impulsions, d'une impulsion « de commande de contre-réaction ».

Les étapes a) et b) peuvent avoir lieu pendant la durée de ladite impulsion « de commande de contre-réaction ».

Selon une possibilité de mise en oeuvre, le procédé peut comprendre en outre, suite à une variation du champ magnétique dans lequel baigne le capteur magnétique selon une rapidité de variation donnée, une étape de : modulation de la fréquence de répétition desdites impulsions du signal d'excitation en fonction de la rapidité de variation donnée.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels:
- les figures 1A-1D illustrent différents signaux représentatifs du fonctionnement d'un dispositif de mesure de champ magnétique doté d'un magnétomètre à fluxgate, et mis en oeuvre suivant l'art antérieur ;
- la figure 2 illustre un exemple de dispositif de mesure de champ magnétique suivant l'art antérieur, doté d'un magnétomètre à fluxgate ;
- les figures 3A-3D illustrent des signaux d'excitation émis en entrée, d'un magnétomètre à fluxgate intégré à un dispositif de mesure de champ magnétique suivant l'art antérieur et des signaux de sortie du magnétomètre ;
- la figure 4 illustre un dispositif de mesure de champ magnétique suivant l'invention, comprenant un capteur de type magnétomètre à fluxgate, des moyens d'excitation pulsée, et des moyens d'échantillonnage ou de détection en sortie du capteur améliorés ;
- les figures 5A et 5B, illustrent respectivement :
   - un premier exemple de mise en oeuvre d'un dispositif de mesure de champ magnétique suivant l'invention, comprenant un capteur de type magnétomètre à fluxgate et des moyens d'échantillonnage améliorés en sortie du capteur,
   - des signaux d'excitation du capteur magnétique et de commande desdits moyens d'échantillonnage, mis en oeuvre au sein d'un tel dispositif ;

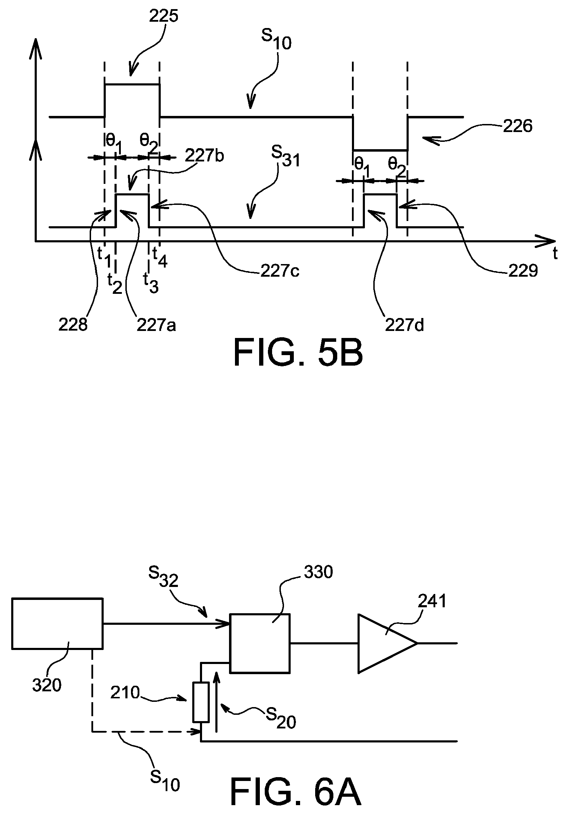

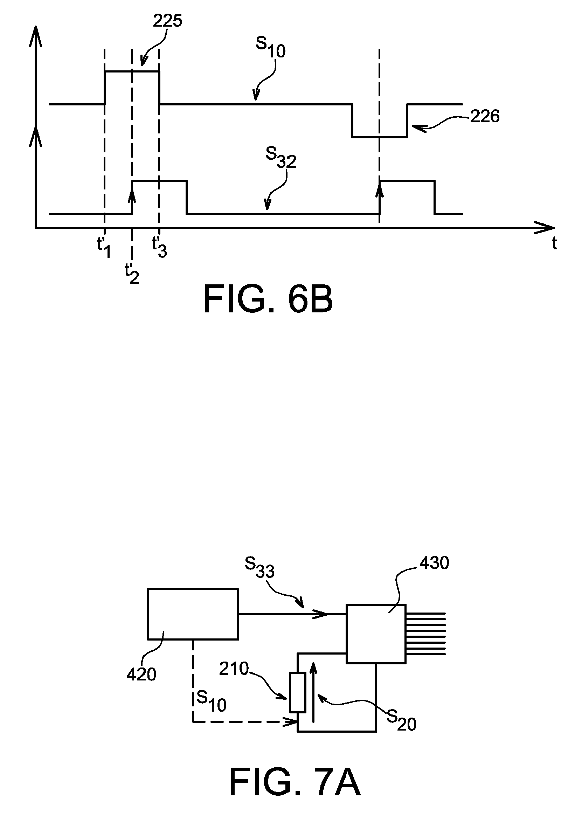

- les figures 6A et 6B, illustrent respectivement :
   - un deuxième exemple de mise en oeuvre d'un dispositif de mesure de champ magnétique suivant l'invention comprenant un capteur de type magnétomètre à fluxgate et des moyens d'échantillonnage améliorés en sortie du capteur,
   - des signaux d'excitation du capteur magnétique et de commande desdits moyens d'échantillonnage, mis en oeuvre au sein d'un tel dispositif ;

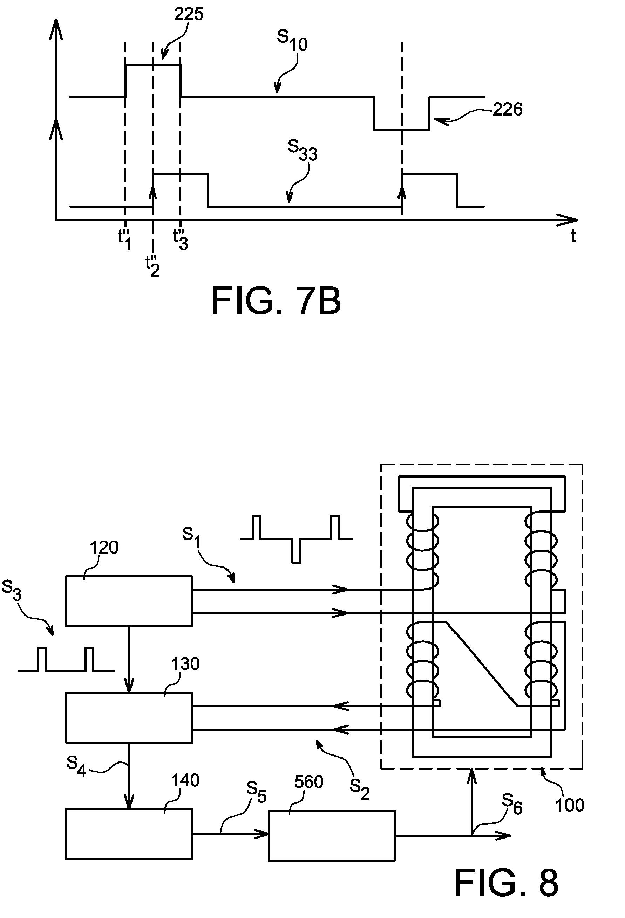

- les figures 7A et 7B, illustrent respectivement :
   - un troisième exemple de mise en oeuvre d'un dispositif de mesure de champ magnétique suivant l'invention comprenant un capteur de type magnétomètre à fluxgate et des moyens d'échantillonnage améliorés en sortie du capteur,
   - et des signaux d'excitation du capteur magnétique et de commande desdits moyens d'échantillonnage, mis en oeuvre au sein d'un tel dispositif ;
- la figure 8 illustre un exemple dispositif de mesure de champ magnétique suivant l'invention à fonctionnement asservi,

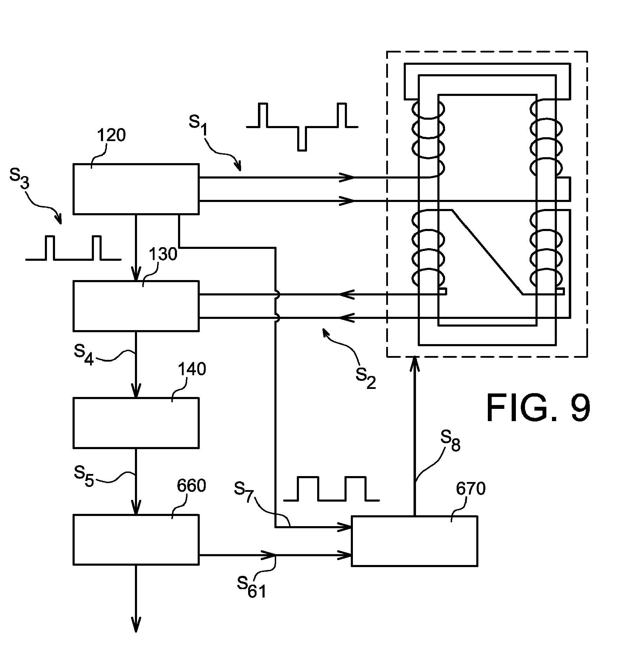

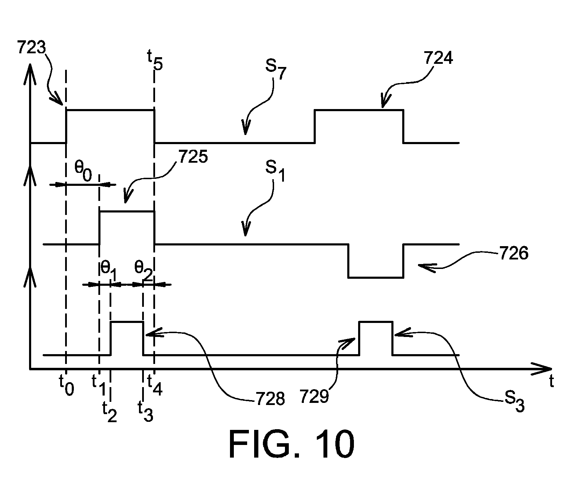

- les figures 9 et 10 illustrent respectivement :
   - un autre exemple de dispositif de mesure de champ magnétique suivant l'invention à fonctionnement asservi et doté de moyens pour générer un signal de contre-réaction, le signal de contre-réaction étant délivré par des moyens régis par un signal de commande « pulsé »,
   - un chronogramme de fonctionnement de cet exemple de dispositif ;

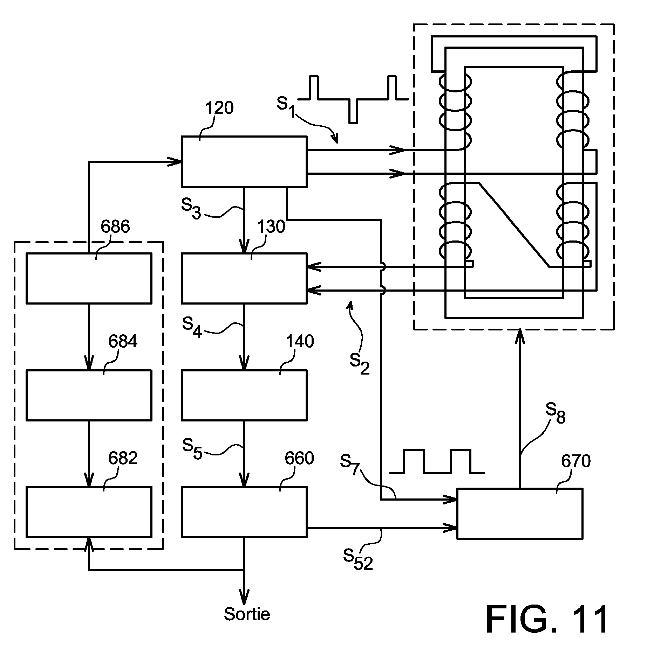

- la figure 11 illustre un autre exemple de dispositif de mesure de champ magnétique suivant l'invention à fonctionnement asservi et doté de moyens pour moduler la fréquence de répétition des impulsions émises vers le circuit magnétique en fonction de la vitesse de variation du champ magnétique dans lequel baigne le capteur magnétique ;

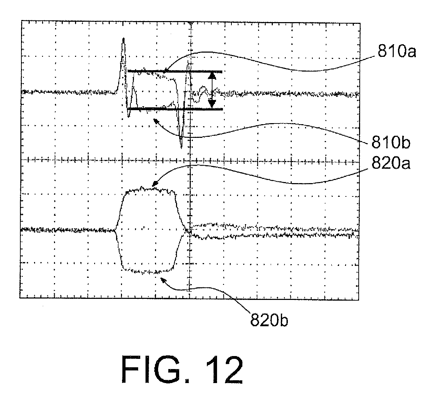

- la figure 12 illustre des signaux de mesures obtenus à l'aide d'un exemple de dispositif mis en oeuvre suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

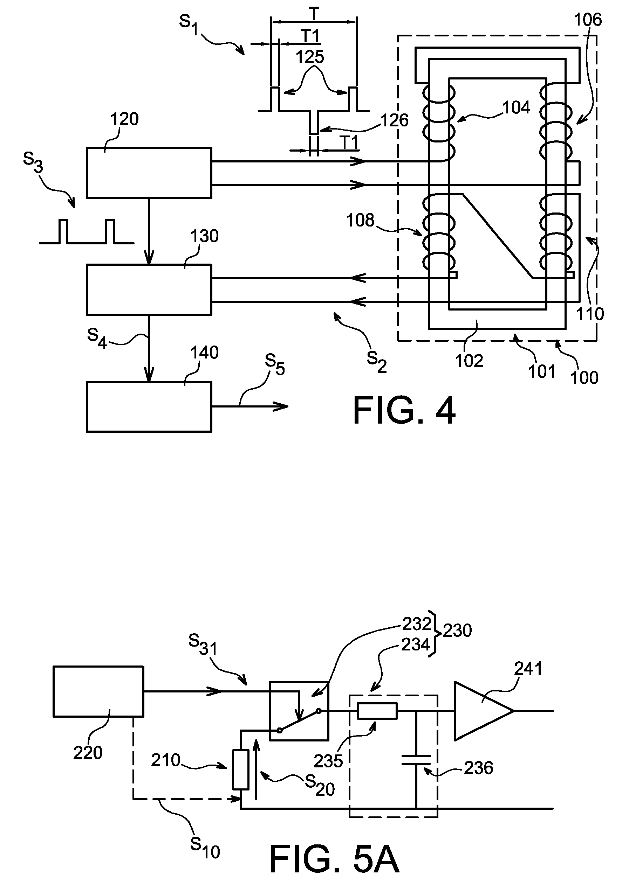

Un exemple de dispositif électronique de détection ou/et de mesure suivant l'invention, comportant un capteur 100 de type magnétomètre, est illustré sur la figure 4. Le capteur 100 peut être en particulier un capteur à fluxgate, ou microfluxgate ou fluxgate intégré, c'est-à-dire un magnétomètre à fluxgate compris dans un dispositif microélectronique tel qu'un MEMS (MEMS pour micro système électromécanique) ou une puce. Le dispositif électronique de détection comprend également des moyens d'excitation ou un circuit d'excitation en entrée du capteur 100, et des moyens de détection ou un circuit de détection en sortie du capteur 100. Le capteur magnétique est formé d'un circuit magnétique 101 doté d'un noyau magnétique 102. Le circuit magnétique 101 peut avoir une forte perméabilité magnétique, par exemple comprise entre 500 et 2000, pour un noyau magnétique à base de Fer/Nickel. Le noyau magnétique 102 peut être fermé. L'invention peut s'appliquer également à des noyaux magnétiques ayant d'autres formes que celui illustré sur la figure 4, et éventuellement à un circuit magnétique comportant un noyau ouvert. Dans le cas d'un micro-fluxgate ou fluxgate intégré, le circuit magnétique peut par exemple avoir une épaisseur de l'ordre de un ou plusieurs micromètres.

Une ou plusieurs bobines d'excitation sont prévues pour saturer le noyau magnétique 102. Le dispositif peut comprendre par exemple un premier bobinage d'excitation 104 et un second bobinage d'excitation 106, reliés en série et enroulés autour des branches du noyau 102. Les bobinages d'excitation 104 et 106 sont agencés de manière à créer un champ magnétique d'excitation dans le noyau magnétique 102. Le dispositif peut comprendre un premier et un second bobinage de détection notés respectivement 108 et 110 également enroulés chacun autour du noyau 102 du circuit magnétique. Le noyau magnétique 102 peut être orienté par exemple selon l'axe dit de « facile aimantation » ou selon l'axe dit de « difficile aimantation ».

Le nombre de bobinages de détection et d'excitation du magnétomètre suivant l'invention, ainsi que l'agencement de ces bobinages n'est nullement limité à celui qui est illustré sur la figure 4. Selon une variante de mise en oeuvre du dispositif, le noyau du circuit magnétique peut être formé de plusieurs branches distinctes ou/et disjointes, par exemple de deux branches comportant chacune une bobine d'excitation et une bobine de détection. Cette variante peut permettre de connecter les bobines selon un montage différentiel, et de limiter ou supprimer ainsi les couplages électromagnétiques, inductifs ou/et capacitifs, entre les bobines d'excitation et de détection. Selon une autre variante, le circuit magnétique peut être formé d'une branche dotée d'une bobine, la bobine étant câblée à un pont de Wheatstone comportant par exemple trois impédances fixes, une desdites impédances présentant la même valeur que la bobine lorsque le circuit magnétique n'est pas saturé.

Un générateur d'impulsions ou des moyens générateurs d'impulsions 120 sont prévus en entrée du circuit magnétique 101, et reliés par exemple à une extrémité du premier bobinage d'excitation 104 et à une extrémité du deuxième bobinage d'excitation 106. Le générateur d'impulsions 120 est prévu pour délivrer un signal d'excitation S₁ qui peut être sous forme d'une succession de brèves impulsions de courant dites « d'excitation » émises en entrée des bobines 104 et 106, et éventuellement périodique. Les impulsions du signal d'excitation S₁ ont une amplitude choisie de manière à saturer le circuit magnétique 101 du capteur 100. Par « brèves impulsions », on entend des impulsions dont la durée ou la largeur T₁ est très courte par rapport à la période du signal d'excitation, par exemple au moins au moins 50 fois inférieure à la période T du signal d'excitation ou au moins 50000 fois inférieure à la période du signal d'excitation. Le générateur d'impulsions 120 est mis en oeuvre pour générer des impulsions d'une durée ou largeur T₁, prévue suffisamment importante pour qu'un signal noté S₂ en sortie du capteur, puisse être exploité par des moyens de détection.

Les impulsions du signal d'excitation S₁ peuvent avoir par exemple une durée ou une largeur au moins supérieure à 10 nanosecondes ou/et au moins inférieure à 30 nanosecondes. Les impulsions du signal d'excitation S₁ peuvent avoir une durée ou une largeur choisie de préférence entre 10 et 30 nanosecondes notamment pour un capteur dont l'épaisseur du noyau ou du circuit magnétique est de l'ordre de 1 µm à plusieurs micromètres et dont la longueur est de l'ordre de 100 µm à plusieurs centaines de micromètres Cet intervalle de temps est choisi en fonction de la constante de temps du circuit.

Pour une fréquence des impulsions du signal d'excitation S₁ de l'ordre de 50 kHz, la durée des impulsions peut être choisie par exemple cent fois plus petite que la période du signal d'excitation, par exemple de l'ordre de 20 nanosecondes. Le courant consommé peut être ainsi 100 fois inférieur à l'amplitude de l'impulsion.

Les impulsions du signal d'excitation S₁ peuvent avoir une forme rectangulaire ou sensiblement rectangulaire. Par forme « sensiblement » rectangulaire, on entend que les impulsions comportent des fronts de durée par exemple de l'ordre de 2 nanosecondes, ou par exemple comprise entre 1 nanoseconde et 5 nanosecondes.

Par rapport à des signaux d'excitation triangulaires ou sinusoïdaux mis en oeuvre dans des dispositifs suivant l'art antérieur, le signal d'excitation S₁ formé d'une succession d'impulsions permet notamment d'obtenir une consommation réduite. Le rapport cyclique et la fréquence du signal d'excitation S₁ généré par les moyens 120, peuvent être modulables, par exemple dans un rapport de 1 à 10000. Des moyens pour moduler la fréquence du signal d'excitation peuvent être prévus.

La fréquence du signal d'excitation S₁ peut être par exemple comprise entre 100 Hz et 1 MHz et choisie, en fonction du type de détection que le capteur 100 est destiné à effectuer.

Une fréquence d'excitation basse, par exemple comprise entre 100 Hz et 1 kHz peut être choisie par exemple pour des applications du capteur qui requièrent une faible consommation, par exemple au moins inférieure à 100 µA sous une tension d'excitation d'amplitude par exemple de l'ordre de 3 volts, mais ne nécessitent pas une bande passante importante, par exemple de l'ordre ou inférieure à 1/10 de la fréquence du signal d'excitation, soit entre 10 Hz et 100 Hz.

Une fréquence d'excitation comprise entre 50 kHz et 500 kHz peut être choisie par exemple pour des applications qui requièrent une bande passante de l'ordre ou d'au moins 10 kHz ainsi qu'un bruit pas plus élevé que 5 nT/Hz^{½}.

Selon une possibilité, le signal d'excitation S₁ peut être sous forme d'une alternance d'impulsions positives 125 et d'impulsions négatives 126 ou être formé d'au moins deux impulsions successives de signes opposés. De cette manière, la composante utile du signal S₂ en sortie du capteur 100 a un signe indépendant de celui des impulsions émises en entrée du capteur 100, tandis que d'éventuels couplages parasites entre les bobinages d'excitation et de détection s'annulent. Les impulsions négatives 126 et les impulsions positives 125 peuvent avoir des largeurs T₁ respectives égales ou/et des amplitudes A respectives égales. Lesdites impulsions positives 125 et négatives 126 peuvent être ainsi symétriques. Un signal d'excitation S₁ mis en oeuvre avec des impulsions symétriques peut permettre de réduire ou supprimer des décalages ou « offsets » dans le signal S₂ en sortie du capteur magnétique.

Selon une possibilité, le signal d'excitation S₁ peut être mis en oeuvre à partir d'un signal carré ou rectangulaire auquel on a appliqué un filtrage passe haut. Le signal d'excitation S₁ peut être éventuellement mis en oeuvre par un circuit CMOS (CMOS pour « semi-conducteur à oxyde de métal complémentaire »).

Des moyens d'échantillonnage 130 sont prévus, pour effectuer, notamment, des acquisitions du signal S₂ en sortie du capteur 100, en fonction d'un signal de commande d'échantillonnage S₃ et en particulier des variations d'un signal de commande d'échantillonnage S₃ ou de l'état d'un signal de commande d'échantillonnage S₃ délivré en entrée des moyens d'échantillonnage 130. Les variations du signal de commande S₃ sont elles-mêmes dépendantes, ou l'état du signal de commande S₃ est lui-même dépendant, des variations du signal S₁ d'excitation.

Des moyens sont mis en oeuvre pour, consécutivement à l'émission ou à la production d'une impulsion dans le signal d'excitation S₁, modifier au moins une fois le signal de commande d'échantillonnage S₃ ou l' état du signal de commande d' échantillonnage S₃, de manière à déclencher au moins une acquisition du signal de sortie S₂ du capteur 100 pendant la durée de cette impulsion d'excitation. Autrement dit, le dispositif de mesure est prévu pour que les moyens d'échantillonnage 130 effectuent une acquisition du signal S₂ en sortie du capteur ou du circuit magnétique à des instants situés pendant les durées respectives des impulsions du signal d'excitation S₁. Selon une mise en oeuvre particulière, des moyens peuvent être mis en oeuvre pour, déclencher au moins une acquisition du signal en sortie du capteur ou du circuit magnétique, consécutivement à chacune des impulsions d'excitation émises, pendant les durées respectives de ces impulsions. Le signal de commande d'échantillonnage S₃ peut être formé et délivré par les moyens 120 générateurs d'impulsions. Le signal de commande d'échantillonnage S₃ peut être par exemple un signal à deux états, tel qu'illustré sur la figure 4.

Les moyens d'échantillonnage 130 produisent en sortie un signal S₄ représentatif d'un champ magnétique mesuré. Le signal S₄ en sortie des moyens d'échantillonnage peut être par exemple une tension analogique ou éventuellement un signal numérique, par exemple un mot numérique. Les moyens d'échantillonnage 130 peuvent comprendre par exemple des moyens formant un échantillonneur-bloqueur. Selon une variante, les moyens d'échantillonnage 130 peuvent comprendre des moyens formant un convertisseur analogique-numérique.

En sortie des moyens d'échantillonnage 130, un étage 140 comprenant des moyens de filtrage passe bas et/ou des moyens d'amplification basse fréquence peut ou peuvent être prévu(s). Cet étage 140 délivre un signal de sortie S₅.

Avec un tel dispositif, on obtient un signal S₂ en sortie du capteur d'amplitude élevée, par exemple de l'ordre de 30 mV pour un champ magnétique à mesurer de l'ordre de 30 µT, ce qui peut permettre de se prémunir d'un amplificateur entre la sortie du capteur magnétique et les moyens d'échantillonnage 130, et en particulier d'un amplificateur haute fréquence. La mise en oeuvre de moyens amplificateurs basse fréquence après les moyens d'échantillonnage 130, plutôt que d'un amplificateur haute fréquence avant les moyens d'échantillonnage 130, peut permettre notamment de diminuer la consommation du dispositif de mesure.

Une variante du dispositif électronique de détection ou/et de mesure suivant l'invention précédemment décrit, doté d'un capteur 210 de type magnétomètre à fluxgate est illustrée sur la figure 5A.

Des moyens générateurs 220 délivrent un signal d'excitation S₁₀ à un capteur ou circuit magnétique 210. Le signal d'excitation S₁₀ peut être du type de celui S₁ décrit précédemment. En sortie du capteur ou circuit magnétique 210, sont prévus des moyens d'échantillonnage 230 aptes à effectuer, au moins une acquisition d'un signal S₂₀ en sortie du capteur 210 pendant chacune des impulsions du signal d'excitation S₁₀. Selon cette variante, les moyens d'échantillonnage 230 peuvent être dotés de moyens formant un interrupteur, par exemple un interrupteur analogique 232, dont l'ouverture et la fermeture sont régies par un signal de commande d'échantillonnage S₃₁ également généré par les moyens 220 générateurs du signal d'excitation S₁₀. Les variations du signal de commande S₃₁ sont dépendantes de celles du signal d'excitation S₁₀. Les moyens d'échantillonnage 230 comprennent également des moyens formant un filtre passe bas 234. Les moyens formant un filtre passe bas 234 peuvent être sous forme par exemple de moyens formant une résistance 235 associés à des moyens formant un condensateur 236. Un amplificateur 241 peut être prévu en sortie du filtre 234. L'amplificateur 241 est doté d'une impédance d'entrée élevée, par exemple supérieure à 10 MΩ, de manière à conserver un signal constant en sortie des moyens d'échantillonnage 230, lorsque l'interrupteur 232 est ouvert. La constante de temps du condensateur 236 et la résistance d'entrée de l'amplificateur est de préférence très supérieure à la plus grande période des impulsions d'excitation, par exemple entre 5 et 10 fois plus grande.

L'amplificateur 241 peut être par exemple agencé selon un montage suiveur. Les moyens d'échantillonnage 230 délivrent un signal représentatif du champ magnétique à mesurer, par exemple sous forme d'une tension analogique.

Sur la figure 5B, sont illustrés des courbes représentatives respectivement, du signal de commande d'échantillonnage S₃₁ par exemple sous forme d'un signal à deux états, et du signal d' excitation S₁₀ émis en entrée du capteur 210. Le signal d'excitation S₁₀ est formé d'une succession d'impulsions 225, 226, alternativement de signes opposés, par exemple positives puis négatives. Consécutivement à l'émission ou à la production d'une première impulsion 225 dans le signal d'excitation S₁ à un instant t₁, le signal de commande d'échantillonnage S₃₁ est modifié ou amené à changer d'état, après un intervalle de temps prédéterminé θ₁ ou un temps ou un délai θ₁ prédéterminé et passe d'un premier état à un deuxième état, par exemple de l'état bas à l'état haut (portion référencée 227a sur la figure 5B), de manière à fermer l'interrupteur 232 et déclencher une acquisition du signal en sortie du capteur par les moyens d'échantillonnage 230. Pour cette variante de mise en oeuvre, l'acquisition du signal S₂₀ en sortie du capteur 210 est réalisée pendant la durée de la première impulsion d'excitation, un délai prédéterminé θ₁ après le début de cette première impulsion. De cette manière, on n'effectue pas de détection au moment où l'impulsion d'excitation 225 est émise ou au début de cette impulsion d'excitation 225, c'est-à-dire à un moment pendant lequel des phénomènes de couplage électromagnétique parasite ou de bruit dans le signal S₂₀ sont susceptibles de survenir.

Le signal de commande S₃₁ est maintenu dans le deuxième état pendant une durée prédéterminée entre un instant t₂ et un instant t₃ (portion référencée 227b sur la figure 5B), de manière à maintenir l'interrupteur fermé pendant cette durée prédéterminée. Autrement dit, l'acquisition du signal en sortie du capteur effectuée pendant la durée de la première impulsion d'excitation 225, est réalisée entre l'instant t₂ et l'instant t₃. Puis, un temps ou délai prédéterminé θ₂ avant la fin de la première impulsion d'excitation 225, le signal de commande S₃₁ d'échantillonnage est modifié ou amené à changer d'état, et passe du deuxième état au premier état, par exemple de l'état haut à l'état bas (portion référencée 227c sur la figure 5B), de manière à ouvrir l'interrupteur 232. Une moyenne ou un lissage de la tension induite en sortie du capteur 210 est également effectué(e) pendant ladite durée de l'impulsion 225, entre l'instant t₂ et l'instant t₃. La durée de la première impulsion 225 s'achève à un instant t₄. Le changement d'état du signal de commande, prévu un délai θ₂ avant t₄, permet de ne pas effectuer de détection au moment où l'impulsion 225 se termine ou à la fin de l'impulsion d'excitation 225, c'est-à-dire à un moment pendant lequel des phénomènes de couplage parasite ou de bruit dans le signal S₃₀ peuvent survenir. Un signal dit « lissé » est formé par lissage du signal de sortie S₂₀ du capteur 210.

Puis, une deuxième impulsion 226 par exemple de signe négatif, est émise. Le signal de commande S₃₁ est modifié ou amené à changer d'état (portion référencée 227d), un délai prédéterminé θ₁ après le début de la deuxième impulsion. Ensuite, un délai prédéterminé θ₂ avant la fin de la deuxième impulsion 226, le signal de commande S₂₁ d'échantillonnage est modifié ou amené à changer d'état, et passe du deuxième état au premier état, par exemple de l'état haut à l'état bas, de manière à ouvrir l'interrupteur 232.

Entre les impulsions 225 et 226 l'interrupteur est maintenu ouvert, et le signal lissé en sortie des moyens d'échantillonnage 230 est mémorisé. Les moyens d'échantillonnage 230 sont prévus pour mémoriser ledit signal « lissé », jusqu'à la deuxième impulsion d'excitation 226.

Une deuxième variante de dispositif électronique de détection ou/et de mesure suivant l'invention doté d'un capteur 210 de type magnétomètre à fluxgate, est illustrée sur la figure 6A. Selon cette variante, en sortie du capteur ou circuit magnétique 210, sont prévus des moyens d'échantillonnage dotés d'un échantillonneur-bloqueur 330. L'échantillonneur-bloqueur 330 délivre un signal représentatif du champ magnétique à mesurer, par exemple sous forme d'une tension. Des moyens générateurs 320 délivrent un signal d'excitation S₁₀, au capteur magnétique 210. En sortie du capteur 210, les moyens d'échantillonnage 330 sont mis en oeuvre pour effectuer, consécutivement à une impulsion du signal d'excitation S₁₀, une acquisition d'un signal S₂₀ en sortie du capteur 210 pendant la durée de cette impulsion. Selon cette variante, les moyens d'échantillonnage 330 sont régis par un signal de commande d'échantillonnage S₃₂ généré par les moyens 320 générateurs du signal d'excitation S₁₀. Les variations du signal de commande S₃₂ sont dépendantes de celles du signal d'excitation S₁₀.

Sur la figure 6B sont illustrées des courbes représentatives respectivement, du signal de commande d'échantillonnage S₃₂, par exemple sous forme d'un signal à deux états, émis en entrée de l'échantillonneur-bloqueur 330 et du signal d'excitation S₁₀, par exemple sous forme d'un courant, émis en entrée du capteur 210. Le signal d'excitation S₁₀ est formé d'une succession d'impulsions 225, 226, alternativement positives puis négatives. Consécutivement à l'émission ou à la production d'une première impulsion 225 dans le signal d'excitation S₁₀ à un instant t'₁, le signal de commande S₃₂ d'échantillonnage est amené à changer d'état et passe d'un premier état à un deuxième état, par exemple de l'état bas à l'état haut, à un instant t'₂ situé pendant la durée de l'impulsion 225. Les moyens générateurs 320 d'impulsions sont, dans cet exemple, mis en oeuvre pour que l'instant t'₂ de changement d'état du signal de commande S₃₂ soit situé au milieu de l'impulsion d'excitation 225. Le changement d'état du signal de commande S₂₂ à l'instant t'₂ provoque une acquisition, par l'échantillonneur-bloqueur 330, du signal en sortie du capteur. A l'instant t'₂, l'échantillonneur-bloqueur 330 mémorise le signal en sortie du capteur. Effectuer une acquisition du signal S₂₀, à un instant situé par exemple au milieu de l'impulsion 225, peut permettre d'obtenir un signal qui ne comporte pas de bruit parasite dû à des phénomènes de couplage électromagnétique lors de transitions ou changement d'états du signal d'excitation.

Une troisième variante de dispositif électronique de détection ou/et de mesure suivant l'invention, doté d'un capteur 210 de type magnétomètre à fluxgate, est illustrée sur la figure 7A. Selon cette variante, en sortie du capteur ou circuit magnétique 210, sont prévus des moyens d'échantillonnage comprenant un convertisseur analogique numérique 430. Le convertisseur 430 délivre un signal représentatif du champ magnétique à mesurer, par exemple sous forme d'un mot numérique.

Sur la figure 7B sont illustrées des courbes représentatives respectivement, d'un signal de commande d'échantillonnage S₃₃ par exemple sous forme d'un signal à deux états, émis en entrée du convertisseur 430 et d'un signal d'excitation S₁₀, tel que décrit précédemment, émis en entrée du capteur 210. Le signal d'excitation S₁₀ est formé d'une succession d'impulsions 225, 226, alternativement positives puis négatives. Consécutivement à l'émission ou à la production d'une première impulsion 225 dans le signal d'excitation S₁₀ à un instant t"₁, le signal de commande S₃₃ d'échantillonnage passe d'un premier état à un deuxième état, par exemple de l'état bas à l'état haut, à un instant t"₂ situé pendant la durée de l'impulsion 225 entre l'instant t"₁ et un instant t"₃ référencés sur la figure 7B, l'instant t"₂ de changement d'état du signal de commande S₃₃ peut être prévu pour être situé au milieu de l'impulsion d'excitation 225. Le changement d'état du signal de commande S₃₃ à l'instant t"₂ provoque notamment une acquisition, par le convertisseur 430, du signal S₂₀ en sortie du capteur 210, ainsi qu'une conversion de ce signal. Effectuer une conversion du signal S₂₀, à un instant situé au milieu de l'impulsion 225, peut permettre d'obtenir un signal dans lequel des phénomènes de bruit parasites dus notamment à des couplages lors de transitions ou changement d'états du signal d'excitation, sont minimisés.

Une variante de l'exemple de dispositif électronique de détection ou/et de mesure suivant l'invention donné précédemment en liaison avec la figure 4, est illustrée sur la figure 8. Pour cette variante, le dispositif de mesure est susceptible d'avoir un fonctionnement asservi et comporte une boucle d'asservissement ou de rétroaction. Un signal représentatif d'un champ magnétique mesuré, par exemple le signal de sortie S₅ de l'amplificateur 140 ou (selon une possibilité non représentée) le mot numérique en sortie d'un convertisseur analogique-numérique (tel que le convertisseur référencé 430 sur la figure 7A) joue le rôle d'un signal d'erreur de la boucle d'asservissement. Ce signal d'erreur est appliqué à l'entrée de moyens formant un intégrateur 560, par exemple un amplificateur intégrateur ou un intégrateur numérique. En sortie de l'intégrateur 560 un signal S₆ dit « de contre réaction », destiné à alimenter une ou plusieurs bobines de contre-réaction est délivré. Les bobines de « contre-réaction » peuvent être, une ou plusieurs des bobines 104, 106 d'excitation ou une ou plusieurs bobines supplémentaires spécifiques (non représentées). L'application d'un signal de contre réaction S₆ aux bobines de contre réaction permet de former un champ magnétique de contre réaction qui s'oppose au champ magnétique dans lequel le capteur 100 baigne. Dans cet exemple, le capteur magnétique 100 fonctionne sous un champ magnétique dont la valeur moyenne est nulle. La dynamique de mesure et la linéarité du dispositif de mesure peuvent être ainsi améliorées.

Une mise en oeuvre particulière du dispositif de mesure de champ magnétique à fonctionnement asservi et à contre réaction dite « pulsée », est illustrée sur la figure 9. Dans cet exemple, des moyens pour appliquer un signal de contre réaction S₈ au capteur magnétique 100, sont régis par un signal de commande de contre réaction S₇ formé d'une succession d'impulsions. Le dispositif comprend ainsi en outre, des moyens de commande 670 aptes à délivrer le signal de contre réaction S₈, et régis par le signal de commande de contre réaction S₇. Ce signal de commande de contre réaction S₇, peut être par exemple un signal logique, délivré par le générateur d'impulsions 120. Dans cet exemple, la boucle de rétroaction comprend des moyens 660 formant au moins un intégrateur, situés en sortie de l'étage 140 amplificateur et de filtrage. Des moyens pour mémoriser une information relative à l'amplitude du signal de contre-réaction entre deux impulsions d'excitation peuvent être également prévus. Selon une mise en oeuvre possible, ces moyens de mémorisation peuvent appartenir à l'intégrateur 660. Les moyens de commande de contre-réaction 670 reçoivent en entrée le signal de sortie S₆₁ de l'intégrateur 660 et sont susceptibles, en fonction de l'état du signal de commande de contre réaction S₇, d'émettre ou non, un signal de contre réaction S₈ dont l'amplitude dépend de celle du signal de sortie S₆₁.

Un fonctionnement du dispositif à contre réaction pulsée va être donné en liaison avec le chronogramme de la figure 10, sur laquelle des courbes représentatives d'un signal de commande de contre réaction S₇, d'un signal d'excitation S₁, et d'un signal de commande d'échantillonnage S₃ sont données. Les signaux S₁, S₃, S₇ peuvent être formés par le générateur d'impulsions 120 et formés respectivement, d'une première succession d'impulsions 723, 724 d'une deuxième succession d'impulsions 725, 726, et d'une troisième succession d'impulsions 728, 729. Les variations du signal d'excitation S₁, sont dépendantes de celles du signal de commande de contre réaction S₇, tandis que les variations du signal de commande d'échantillonnage S₃ sont dépendantes de celles du signal d'excitation S₁.

A partir d'un instant t₀, le signal de commande de contre réaction S₇ change d'état. Un signal de contre-réaction S₈ (non représenté sur cette figure), dont l'amplitude a été définie et mémorisée par l'intégrateur 660 lors d'un échantillonnage précédent, est alors appliqué aux bobines de contre-réaction du capteur 100 à partir de l'instant t₀.

Puis, après un temps prédéterminé θ₀, une impulsion d'excitation 725 est émise à un instant t₁. Le temps prédéterminé θ₀ est prévu de manière à permettre l'établissement d'un champ magnétique de contre-réaction à une valeur précise, et peut être par exemple tel que θ₀= 5τ avec τ la constante de temps du circuit magnétique du capteur 100.

Ensuite, un temps prédéterminé θ₁ après l'instant t₁, le signal S₂ de sortie des bobinages de détection 108, 110, est échantillonné par les moyens d'échantillonnage 130, amplifié par les moyens 140 et appliqué en entrée de l'intégrateur 660. L'intégrateur 660 corrige éventuellement le signal de contre-réaction afin de tendre à annuler le signal de sortie S₂ des bobines 108, 110 de détection. Une nouvelle valeur du signal de contre-réaction est mémorisée jusqu'à l'échantillon suivant.

Puis, l'échantillonnage du signal de sortie S₂ des bobines de détection est interrompu à un instant t₃. L'impulsion d'excitation se termine ensuite à un instant t₄, un temps prédéterminé θ₂ après l'instant t₃. L'impulsion de commande de contre-réaction se termine ensuite à un instant t₅. A partir de l'instant t₅ et jusqu'à un échantillon suivant, la contre réaction est stoppée.

Après plusieurs échantillons permettant la stabilisation de la boucle d'asservissement, la valeur du signal de contre-réaction mémorisée est l'image du champ magnétique dans lequel baigne le capteur magnétique et que l'on souhaite mesurer.

Dans cet exemple de mise en oeuvre, les impulsions 728, 729 du signal de commande d'échantillonnage S₃ sont situées respectivement pendant les durées respectives des impulsions du signal d'excitation S₁, les impulsions d'excitations 725, 726 étant elles mêmes respectivement situées pendant les durées des impulsions 723, 724, du signal de commande de contre réaction S₇.

Un variante de l'exemple de dispositif précédent, à fonctionnement asservi va à présent être donnée en liaison avec la figure 11. Pour cette variante, le dispositif a un fonctionnement dit « auto-adaptatif ». Par « auto-adaptatif », on entend que la fréquence de répétition des impulsions d'excitations émises par les moyens générateurs 120 peut être réglée de manière automatique au sein du dispositif, en fonction de la vitesse ou rapidité de variation du champ magnétique à mesurer environnant le capteur 100. Dans cet exemple de réalisation, des moyens sont ainsi mis en oeuvre pour moduler la fréquence de répétition des impulsions d'excitation du signal S₁ délivré par les moyens générateurs 120, en fonction de la vitesse de variation ou rapidité de variation du champ magnétique à mesurer environnant le capteur 100. Ces moyens de modulation peuvent comprendre par exemple des moyens 682 formant un dérivateur, reliés à une sortie de l'intégrateur 660, des moyens 684 formant un redresseur sans seuil, reliés à une sortie des moyens formant un dérivateur 682, ainsi que des moyens 686 formant un oscillateur commandé en tension, reliés à une sortie des moyens formant un redresseur 684, les moyens 686 formant un oscillateur étant reliés aux moyens 120 générateurs d'impulsions.

Un tel dispositif peut être prévu par exemple pour que, lorsque le champ magnétique environnant est constant ou varie lentement, la fréquence de répétition des impulsions d'excitation est basse, tandis que lorsque le champ magnétique varie rapidement, la fréquence de répétition des impulsions d'excitation est élevée. Un tel mode de fonctionnement peut permettre d'optimiser la consommation.

Un dispositif de boussole comprenant un tel type de dispositif de mesure de champ magnétique auto-adaptatif et à fonctionnement asservi, peut être mis en oeuvre selon l'invention et prévu par exemple pour que la fréquence des mesures de champ magnétique varie selon que la boussole est immobile ou en mouvement. Le fonctionnement du dispositif de boussole mis en oeuvre suivant l'invention peut être le suivant : quand le capteur 100 est immobile, le champ magnétique à mesurer est constant ou sensiblement constant et le signal de sortie est également constant. Le signal en sortie du dérivateur 682 est alors nul, le signal en sortie du redresseur sans seuil 684 est nul et la fréquence de répétition des impulsions d'excitation est minimale, par exemple de l'ordre de 100 Hz. Lorsque le capteur 100 est mis en mouvement, le champ magnétique est variable, et le signal de sortie est également variable. Le signal en sortie du dérivateur 682 est alors non nul, tandis que le signal en sortie du redresseur sans seuil 684 est positif et la fréquence de répétition des impulsions d'excitation est élevée, par exemple de l'ordre de 100 kHz. Ainsi, la bande passante est basse quand le champ magnétique varie peu, et élevée quand le champ magnétique varie rapidement. Un tel dispositif de boussole, peut être doté de deux capteurs du type du capteur 100, positionnés à 90°, et mis en en oeuvre de sorte que la direction du Nord est calculée en fonction du signal de sortie S₄ de chacun de ces deux capteurs.

La figure 12 illustre des signaux de mesure 810a et 810b dits « signaux utiles » obtenus à l'aide d'un des dispositifs précédemment décrits et en réponse à respectivement à une première impulsion d'excitation 820a et à une deuxième impulsion d'excitation issues des moyens générateurs d'impulsion 120, et montre qu'une détection « échantillonnée » mise en oeuvre suivant l'invention peut permettre d'exploiter l'amplitude crête à crête du signal de mesure.

## Revendications

1. Dispositif de mesure de champ magnétique doté d'un magnétomètre à fluxgate, le dispositif comprenant:
- un capteur magnétique (100,210) doté d'au moins un noyau magnétique (102) et d'une pluralité de bobinages (104,106,108,110), et apte à délivrer au moins un signal de sortie (S₂, S₂₀),
- des moyens générateurs d'impulsions (120,220) aptes à émettre au moins un signal d'excitation (S₁, S₁₀) en entrée du capteur magnétique, sous forme d'une succession d'impulsions (125,126,225, 226,725,726) dites « d'excitation »,
- des moyens d'échantillonnage (130,230,330,430) du signal de sortie (S₂, S₂₀) du capteur magnétique (100,210),
le dispositif comprenant en outre des moyens pour, consécutivement à l'émission d'au moins une impulsion d'excitation de ladite succession d'impulsions d'excitation et pendant la durée de ladite impulsion d'excitation, déclencher au moins une acquisition du signal de sortie (S₂) du capteur magnétique (100,210) par lesdits moyens d'échantillonnage (130,230,330,430).

2. Dispositif selon la revendication 1, le signal d'excitation (S₁, S₁₀) étant formé d'impulsions d'excitation successives (125,126,225,226,725,726) de signes opposés.

3. Dispositif selon l'une des revendications 1 ou 2, lesdites impulsions d'excitation (125,126, 225, 226,725,726) ayant des durées respectives ou/et des amplitudes respectives égales.

4. Dispositif selon l'une des revendications 1 à 3, lesdites impulsions d'excitation (125,126,225, 226,725,726) ayant une forme rectangulaire.

5. Dispositif selon l'une des revendications 1 à 4, dans lequel les moyens d'échantillonnage (130,230,330,430) sont régis par au moins un signal de commande d' échantillonnage (S₃, S₃₁, S₃₂,S₃₃) à deux états, généré par les moyens générateurs d'impulsions (120,220).

6. Dispositif selon l'une des revendications 1 à 5, les moyens d'échantillonnage (130,230,330,430) étant aptes consécutivement à ladite émission de ladite impulsion excitation, à effectuer au moins une acquisition du signal (S₂,S₂₀) de sortie du capteur magnétique (100,210) pendant un intervalle de temps donné inférieur à la durée de ladite impulsion, ledit intervalle de temps étant compris entre un instant situé un premier délai (θ₁) prédéterminé après le début de ladite impulsion et un instant situé un deuxième délai (θ₂) prédéterminé avant la fin de ladite impulsion d'excitation.

7. Dispositif selon la revendication 6, les moyens d'échantillonnage (230) étant aptes, en outre, à effectuer une moyenne ou un lissage du signal de sortie (S₂,S₂₀) du capteur magnétique (100,210) pendant ledit intervalle de temps donné.

8. Dispositif selon la revendication 7, dans lequel un signal dit « lissé » est formé suite à ladite moyenne ou audit lissage dudit signal de sortie, les moyens d'échantillonnage (230) étant aptes en outre à mémoriser ledit signal « lissé », après ledit intervalle de temps donné et jusqu'à au moins une autre impulsion d'excitation de ladite succession d'impulsions d'excitation.

9. Dispositif selon l'une des revendications 6 à 8, les moyens d'échantillonnage (230) comprenant des moyens (232) formant un interrupteur analogique.

10. Dispositif selon l'une des revendications 6 à 9, les moyens d'échantillonnage (230) comprenant des moyens (234) formant un filtre passe bas.

11. Dispositif selon l'une des revendications 1 à 5, les moyens d'échantillonnage étant aptes consécutivement à ladite émission de ladite impulsion d'excitation, à effectuer au moins une acquisition du signal (S₂, S₂₀) de sortie du capteur (100,210) à un instant donné prédéterminé situé après le début et avant la fin de ladite impulsion d'excitation.

12. Dispositif selon la revendication 11, ledit instant donné prédéterminé étant situé au milieu de ladite impulsion d'excitation.

13. Dispositif selon la revendication 11 ou 12, les moyens d'échantillonnage étant aptes à effectuer une mémorisation du signal (S₂₀) de sortie du capteur (210) audit instant donné prédéterminé.

14. Dispositif selon l'une des revendications 11 à 13, les moyens d'échantillonnage (130,330) comprenant au moins un échantillonneur-bloqueur.

15. Dispositif selon la revendication 12 ou 13, les moyens d'échantillonnage (430) étant aptes en outre à effectuer une conversion analogique numérique du signal (S₃) de sortie du capteur audit instant donné prédéterminé.

16. Dispositif selon l'une des revendications 1 à 15, dans lequel le dispositif est susceptible d'adopter un fonctionnement asservi et comprend un ou plusieurs bobinages de contre réaction, et une boucle de rétroaction dotée de moyens (560,660,670) pour produire un signal de contre réaction (S₆, S₈) destiné auxdits bobinages de contre réaction.

17. Dispositif selon la revendication 16, lesdits moyens pour produire un signal de contre réaction (S₆, S₈) comprenant des moyens (560,660) formant au moins un intégrateur.

18. Dispositif selon l'une des revendications 16 ou 17, lesdits moyens pour produire un signal de contre réaction (S₆,S₈) comprenant des moyens (660) pour mémoriser une information relative à l'amplitude dudit signal de contre réaction (S₆,S₈), entre deux impulsions d'excitation.

19. Dispositif selon l'une des revendications 15 à 18, dans lequel les moyens pour produire un signal de contre réaction (S₆,S₈) sont régis par au moins un signal de commande de contre réaction (S₇) généré par les moyens générateurs d'impulsions (120,220) sous forme d'une succession d'impulsions dites « de commande de contre réaction » (125,126, 225, 226).

20. Dispositif selon l'une des revendications 1 à 19, dans lequel ledit capteur magnétique (100,210) baigne dans un champ magnétique, le dispositif comprenant en outre: des moyens pour, consécutivement à une variation du champ magnétique selon un rapidité donnée dans lequel baigne le capteur magnétique (100,210), moduler la fréquence de répétition desdites impulsions du signal d'excitation (S₁, S₁₀) en fonction de ladite rapidité donnée de variation.

21. Procédé de mesure de champ magnétique à l'aide d'un dispositif doté d'un magnétomètre à fluxgate, le dispositif comprenant :
- un capteur magnétique (210), doté d'au moins un noyau magnétique (102) et d'une pluralité de bobinages (104,106,108,110), et apte à délivrer au moins un signal de sortie (S₂,S₂₀),
- des moyens d'excitation du noyau magnétique, comportant des moyens générateurs d'impulsions (120,220) aptes à émettre au moins un signal d'excitation (S₁, S₁₀) en entrée du capteur magnétique sous forme d'une succession d'impulsions dites « d'excitation » (125,126,225,226,725,726),
- des moyens d'échantillonnage (130,230,330,430) du signal de sortie (S₂,S₂₀) du capteur magnétique (110,210), le procédé comprenant les étapes consistant à :
a) émettre au moins une impulsion d'excitation en entrée du capteur magnétique,
b) déclencher, consécutivement à ladite émission de ladite impulsion d'excitation, au moins une acquisition du signal de sortie (S₂,S₂₀) du capteur magnétique par les moyens d'échantillonnage pendant la durée de ladite impulsion d'excitation.

22. Procédé selon la revendication 21, le signal d'excitation (S₁, S₁₀) étant formé d'impulsions successives (125,126,225,226,725,726) de signes respectifs opposés.

23. Procédé selon l'une des revendications 20 ou 21, lesdites impulsions (125,126,225,226,725, 726) ayant des durées respectives ou/et des amplitudes respectives égales.

24. Procédé selon l'une des revendications 21 à 23, lesdites impulsions (125,126,225,226,725,726) ayant une forme rectangulaire.

25. Procédé selon l'une des revendications 21 à 24, dans lequel les moyens d'échantillonnage sont régis par au moins un signal de commande (S₃, S₃₁, S₃₂, S₃₃) à deux états, généré par les moyens générateurs d'impulsions (120,220,420).

26. Procédé selon l'une des revendications 21 à 25, comprenant en outre : consécutivement à ladite émission de ladite impulsion d'excitation donnée, au moins une acquisition du signal (S₂, S₂₀) de sortie du capteur (210) pendant un intervalle de temps donné inférieur à la durée de ladite impulsion, ledit intervalle de temps étant compris entre un instant situé un premier délai (θ₁) prédéterminé après le début de ladite impulsion et un instant situé un deuxième délai (θ₂) prédéterminé avant la fin de ladite impulsion donnée.

27. Procédé selon la revendication 26, comprenant en outre: une étape consistant à effectuer une moyenne ou un lissage du signal de sortie (S₂, S₂₀) du capteur magnétique pendant ledit intervalle de temps donné.

28. Procédé selon la revendication 27, dans lequel un signal dit « lissé » est formé suite à ladite moyenne ou audit lissage du signal de sortie, les moyens d'échantillonnage étant aptes en outre à mémoriser ledit signal « lissé », après ledit intervalle de temps donné et jusqu'à au moins une autre impulsion de ladite succession d'impulsions.

29. Procédé selon l'une des revendications 21 à 25, comprenant consécutivement à ladite émission de ladite impulsion, au moins une acquisition du signal (S₂, S₂₀) de sortie du capteur (210) à un instant donné prédéterminé situé après le début et avant la fin de ladite impulsion d'excitation donnée.

30. Procédé selon la revendication 29, ledit instant donné prédéterminé étant situé au milieu de ladite impulsion d'excitation donnée.

31. Procédé selon la revendication 29 ou 30, comprenant en outre: une mémorisation du signal (S₂,S₂₀) de sortie du capteur audit instant donné prédéterminé.

32. Procédé selon la revendication 29 ou 30, comprenant en outre : une conversion analogique numérique du signal (S₃) de sortie du capteur audit instant donné prédéterminé.

33. Procédé selon l'une des revendications 21 à 32, dans lequel le dispositif comprend en outre: un ou plusieurs bobinages de contre réaction, et une boucle de rétroaction dotée de moyens pour produire un signal de contre réaction (S₆,S₈) destiné auxdits bobinages de contre réaction, et dans lequel les moyens pour produire ledit signal de contre réaction (S₆, S₈) sont régis par au moins un signal de commande de contre réaction (S₇) généré par les moyens générateurs d'impulsions (120,220) sous forme d'une succession d'impulsions dites « de commande de contre réaction » (125,126,225,226), ladite impulsion d'excitation émise à l'étape a) ayant été déclenchée consécutivement à une émission par les moyens générateurs d'impulsions, d'une impulsion « de commande de contre-réaction ».

34. Procédé selon la revendication 33, les étapes a) et b) ayant lieu pendant la durée de ladite impulsion « de commande de contre-réaction ».

35. Procédé selon l'une des revendications 21 à 34, comprenant en outre, suite à une variation selon une rapidité de variation donnée du champ magnétique dans lequel baigne le capteur magnétique (100,210) une étape de modulation de la fréquence de répétition desdites impulsions du signal d'excitation (S₁,S₁₀) en fonction de la rapidité de variation donnée.
